# EUROPEAN PATENT APPLICATION

(11) **EP 4 794 459 A2**
(43) Date of publication of application: **19.08.2026**
(21) Application number: 26158273.8
(22) Date of filing: 12.02.2026
(51) Int. Cl.: H05K 3/40, H05K 3/00, H05K 3/42, H05K 1/03, H05K 3/3468

(54) **SUBSTRATE HAVING FINE THROUGH-HOLES FILLED WITH METAL AND MANUFACTURING METHOD THEREOF**

(30) Priority: 13.02.2025 JP 2025021158
(71) Applicant: Tanigurogumi Corporation, Nasushiobara-shi Tochigi 329-2921 (JP)
(72) Inventor: WATANABE, Genzo, Utsunomiya-shi 320-0035 (JP)
(74) Representative: Dunleavy, Christopher Squire

(57) **Abstract**

A substrate (10) having a plurality of fine through-holes (2) filled with metal (3), comprising a conductive layer (3a, 3b) formed on an inner wall surface of each through-hole (2) and a metal solder layer (3c) formed by solidification of a nickel-containing molten solder (5) that has been treated with an organic fatty acid-containing solution (21). The conductive layer includes a copper plating layer (3b) on the metal solder layer (3c) side. An intermetallic compound layer (4) that suppresses copper dissolution is formed at the interface between the copper plating layer (3b) and the metal solder layer (3c). The substrate (10) is preferably a glass or quartz substrate (1). Also provided is a manufacturing method thereof.

## Description

### Cross-Reference to Related Application

This application claims the benefit of Japanese Patent Application No. 2025-021158, filed on February 13, 2025, the entire contents of which are incorporated herein by reference.

### Field of the Invention

The present invention relates to a highly reliable substrate in which fine through-holes are filled with metal, as well as a manufacturing method thereof, enabling high-density mounting and improved reliability.

### BACKGROUND ART

With the progress in electronic devices toward reductions in size, thickness, and weight, and increases in speed, functionality, and multifunctionality, substrates that mount electronic components such as semiconductor devices at high density are making advances in reducing size and thickness, and narrowing a pitch and increasing a pin count in external electrode terminals. Substrates called ball grid arrays (BGAs) and chip size packages (CSPs) are examples of these substrates, and substrates with various structures have been proposed by semiconductor manufacturers and substrate manufacturers. On the other hand, printed wiring boards that mount electronic components such as semiconductor devices require refining in circuit wiring and multilayering in wiring boards to accommodate complex circuit wiring and to support the narrowing in pitch and the increase in pin count of the semiconductor devices.

As multilayer substrates, through-hole multilayer substrates obtained by connecting circuits between layers by through-holes, interstitial via hole (IVH) multilayer substrates obtained by connecting layers by IVHs, build-up substrates fabricated by build-up methods, and the like are known. In particular, in recent years, glass substrates and quartz substrates are preferably utilized as substrates. Glass substrates and quartz substrates have advantages such as high degrees of freedom in thickness and size, ease of availability, relatively low cost, excellent smoothness and flatness, benefits in fine wiring formability with narrow pitch, small coefficients of linear thermal expansion, excellent mounting stability and dimensional stability, excellent chemical stability, and high insulation properties and excellent transmission characteristics. Further, glass substrates and quartz substrates are beneficial in that technologies for electric-discharge machining and laser machining fine through-holes therein are also advancing. This has led to a demand for using glass substrates and quartz substrates as substrates, lengthening through-holes, and making the through-hole smaller in diameter and narrower in pitch.

Technologies for filling such through-holes with metal have also been proposed. As such through-hole filling technologies, generally, through-holes are formed by electric-discharge machining, laser machining, or the like. Then, first, a thin metal layer is formed inside the through-holes by known methods such as a sputtering method, a vapor deposition method, a chemical vapor deposition (CVD) method, or an electroless plating method to perform conductive treatment and, second, electroplating is performed by energizing the thin metal layer as a whole, thereby filling the through-holes with metal. In such conventional methods, to completely fill a fine through-hole of 50 µm, for example, by electroplating, it is necessary to plate an inner wall surface to a thickness of about 25 µm. However, such fine through-holes have a large aspect ratio of substrate thickness (through-hole length) to hole diameter (through-hole diameter), making it difficult to fill the inner wall surface with an electroplating layer. Further, there is also a possibility that voids or seams occur in through-hole conductors.

Various technologies have been proposed for such problems. For example, Patent Document 1 proposes a glass circuit substrate that does not necessarily fill the through-holes with metal, but is capable of fine circuit formation. This technology includes laminating, on both sides of a glass core substrate, a first insulating resin having favorable fillability of through-hole interiors, the glass core substrate with metal circuits formed in the through-holes and on both sides of the glass, thereby effectively suppressing voids generated in the through-holes to achieve long-term connection reliability. Furthermore, the first insulating resin increases a filling amount of inorganic filler to suppress curing shrinkage of insulating resin filled in the through-hole interiors, thereby suppressing dents caused by curing shrinkage directly above the through-holes to ensure flatness of a resin surface.

Further, Patent Document 2 also proposes a wiring board that does not necessarily fill the through-holes with metal, but is formed with numerous through-holes with a copper plating layer deposited on the through-hole inner wall surfaces and the through-hole interiors filled with resin. This technology includes eliminating variations in thickness of the copper plating layer in accordance with an existence density of the through-holes to improve quality, and filling the through-hole interiors with a conductive filler, with a plating film having a substantially uniform thickness formed along the through-hole inner wall surfaces.

### PRIOR ART DOCUMENTS

### Patent Documents

Patent Document 1: Japanese Laid-Open Patent Application Publication No. 2020-182006
Patent Document 2: Japanese Laid-Open Patent Application Publication No. 2023-131615
Patent Document 3: Japanese Patent No. 5129898
Patent Document 4: Japanese Patent No. 6150881

### SUMMARY OF THE INVENTION

### Problems to be Solved by the Invention

As represented by the conventional examples described above, research for using glass substrates and quartz substrates having excellent characteristics as substrates to enable a reduction in diameter and a narrowing in pitch of long through-holes with high reliability is currently underway. However, because a conductive layer is formed on the inner wall surfaces of the through-holes by an electroplating method, there is a risk that a plating liquid or chemical components constituting the plating liquid may remain in the through-holes, or defects or voids may occur in the through-hole conductors, resulting in failure to exhibit high reliability.

The present invention has been made to solve the problems described above, and an object thereof is to provide a substrate having fine through-holes filled with metal that is a highly reliable substrate obtained by filling fine through-holes with metal and facilitates high-density mounting and high reliability, and a manufacturing method thereof.

### Means for Solving the Problems

The present inventors, in the technologies proposed in Patent Documents 3 and 4, have proposed manufacturing methods of substrates and electronic components that can significantly suppress copper dissolution such as seen in conventional dipping treatment and, moreover, prevent copper dissolution in various subsequent mounting steps. The present invention further utilizes and applies such technologies of the present inventors to glass substrates and quartz substrates to enable a reduction in diameter and a narrowing in pitch of long through-holes with high reliability, thereby solving the above-described problems.
(1) A substrate having fine through-holes filled with metal according to the present invention is a substrate having fine through-holes filled with metal comprising a substrate formed with a plurality of fine through-holes. Each of the plurality of fine through-holes is filled with a conductive layer formed on an inner wall surface thereof, and a metal solder layer formed on the conductive layer. The conductive layer is provided with a copper plating layer on the side facing the metal solder layer. The metal solder layer is obtained by being filled with a nickel-containing molten solder treated with an organic fatty acid-containing solution.

A metal solder layer obtained by solidification of a molten solder is formed on the conductive layer formed on the inner wall surfaces of the fine through-holes, filling the fine through-holes with the metal solder layer. In the fine through-holes filled with such a metal solder layer, a plating liquid and chemical components constituting the plating liquid such as in the prior art do not remain, and defects and voids do not occur in the filled metal layer. As a result, a substrate having fine through-holes filled with metal, which facilitates high-density mounting and provides high reliability, can be obtained. Further, the molten solder is purified by treatment with the organic fatty acid-containing solution, and thus oxygen components, metal oxides, impurities, and the like present in the molten solder are purified and removed, resulting in an advantage that defects and voids are not formed in the metal solder layer. Furthermore, the molten solder contains nickel, and thus the nickel, together with copper and tin, forms on the conductive-layer side an intermetallic compound layer containing Cu, Ni, and Sn. As a result, copper dissolution in the copper plating layer can be prevented, and the formation of Cu-Sn intermetallic compounds with inferior mechanical strength can be suppressed. It should be noted that the molten solder treated with the organic fatty acid-containing solution has low oxygen content compared with untreated molten solder, and the difference can be confirmed in that a fine granular crystal structure is observed and a columnar structure such as that of the untreated molten solder is not observed.

Further, when the metal solder layer is formed with the molten solder treated with the organic fatty acid-containing solution, the organic fatty acid-containing solution is in a state of having infiltrated into the fine through-holes, and thus the molten solder treated with the organic fatty acid-containing solution readily infiltrates into the fine through-holes. As a result, both long and small-diameter through-holes can be readily filled with the metal solder layer and enable the formation of smaller-diameter and narrower-pitch through-holes with high reliability.

In the substrate having fine through-holes filled with metal according to the present invention, the substrate is a quartz substrate or a glass substrate.

By applying a quartz substrate or a glass substrate that has advantages such as high degrees of freedom in thickness and size, ease of availability, relatively low cost, excellent smoothness and flatness, benefits in fine wiring formability with narrow pitch, small coefficients of linear thermal expansion, excellent mounting stability and dimensional stability, excellent chemical stability, and high insulation properties and excellent transmission characteristics, and that allows fine through-holes to be formed by electric-discharge machining or laser machining, it is possible to provide a substrate having fine through-holes filled with metal that facilitates high-density mounting and high reliability.

In the substrate having fine through-holes filled with metal according to the present invention, an intermetallic compound layer that combines with a copper component constituting the conductive layer to prevent copper dissolution is formed on the conductive layer side of the metal solder layer.

The metal solder layer is obtained by being filled with the nickel-containing molten solder treated with the organic fatty acid-containing solution, and thus the nickel, together with copper and tin, form an intermetallic compound layer that prevents the copper dissolution on the conductive layer side of the metal solder layer. As a result, the generation of the intermetallic compound layer suppresses copper dissolution in the copper plating layer constituting the conductive layer and the generation of a copper-tin alloy having inferior mechanical strength.

In the substrate having fine through-holes filled with metal according to the present invention, the metal solder layer contains tin as a main component and at least nickel as a subcomponent.

A metal solder layer having such a component composition is formed, thereby providing a substrate with high-reliability filled fine through-holes.

In the substrate having fine through-holes filled with metal according to the present invention, the conductive layer is composed of a first conductive layer formed on the inner wall surface and a second conductive layer formed on the first conductive layer, and the second conductive layer is a copper plating layer or a copper alloy plating layer.

The conductive layer may have a two-layer structure of the first conductive layer and the second conductive layer composed of a copper plating layer or a copper alloy plating layer. It should be noted that the second conductive layer is preferably an electroless plating layer readily formed with uniform plating thickness.

In the substrate having fine through-holes filled with metal according to the present invention, the first conductive layer is made from a conductive material selected from ITO, Cr, Ti, Al, Au, Ag, Cu, Ni, and Mo, or a composite material thereof. Preferably, the first conductive layer is a physical vapor deposition (PVD) film or a chemical vapor deposition (CVD) film.

The first conductive layer is made from the above-described material, making it possible to readily form the second conductive layer composed of a plating layer. It should be noted that the first conductive layer is preferably a PVD film or a CVD film.

(2) A manufacturing method of a substrate having fine through-holes filled with metal according to the present invention is a manufacturing method of a substrate having fine through-holes filled with metal including a substrate formed with a plurality of fine through-holes filled with a metal solder layer. The manufacturing method comprises a conductive layer forming step of forming, on an inner wall surface of each of the plurality of fine through-holes, a conductive layer composed of a copper plating layer or a copper alloy plating layer on the metal solder layer side, and a metal solder layer forming step of supplying a liquid flow of a nickel-containing molten solder treated with an organic fatty acid-containing solution onto the conductive layer on the inner wall surface to fill the fine through-hole with the metal solder layer.

In the manufacturing method of a substrate having fine through-holes filled with metal according to the present invention, the metal solder layer forming step includes, after supplying the liquid flow of the nickel-containing molten solder (molten solder supplying step), a molten solder removing step of removing excess molten solder. The excess molten solder is removed by the molten solder removing step. It should be noted that the removal of the molten solder is preferably performed by injecting a liquid flow of the organic fatty acid-containing solution.

In the manufacturing method of a substrate having fine through-holes filled with metal according to the present invention, the substrate is a quartz substrate or a glass substrate. By applying a quartz substrate or a glass substrate having a small coefficient of linear thermal expansion and excellent dimensional stability and chemical stability, it is possible to manufacture a substrate having fine through-holes filled with metal that facilitates high-density mounting and high reliability.

In the manufacturing method of a substrate having fine through-holes filled with metal according to the present invention, the molten solder preferably contains tin as a main component and at least nickel as a subcomponent.

In the manufacturing method of a substrate having fine through-holes filled with metal according to the present invention, the organic fatty acid-containing solution is a solution containing palmitic acid having 16 carbons.

The manufacturing method of a substrate having fine through-holes filled with metal according to the present invention further comprises, after the conductive layer forming step and before the metal solder layer forming step, an organic fatty acid-containing solution infiltrating step of infiltrating the organic fatty acid-containing solution into the plurality of fine through-holes. The organic fatty acid-containing solution is infiltrated into the fine through-holes before formation of the metal solder layer, making it possible to readily infiltrate the molten solder treated with the organic fatty acid-containing solution into the fine through-holes. As a result, long or small-diameter through-holes can be readily filled with the metal solder layer, enabling a reduction in diameter and a narrowing in pitch of the through-holes with high reliability.

In the manufacturing method of a substrate having fine through-holes filled with metal according to the present invention, the organic fatty acid-containing solution infiltrating step includes, before infiltrating the organic fatty acid-containing solution into the plurality of fine through-holes, a liquid infiltrating step of infiltrating a cleaning liquid or a surface treatment liquid into the plurality of fine through-holes.

A liquid (cleaning liquid or surface treatment liquid) is infiltrated into the fine through-holes in advance, making it possible to readily perform a liquid-liquid exchange between the liquid and the organic fatty acid-containing solution. As a result, the organic fatty acid-containing solution can infiltrate throughout every corner of the fine through-holes, selectively capture and remove oxides and impurities (including plating liquid component residues) present on conductive layer surfaces inside the fine through-holes by the organic fatty acid-containing solution and clean the conductive layer surfaces. It should be noted that the cleaning liquid may be an aqueous solvent or an organic solvent, and the surface treatment liquid may be an oxide removing solution or the like.

In the manufacturing method of a substrate having fine through-holes filled with metal according to the present invention, a viscosity of the molten solder is within a range of 0.002 Pa·s to 0.004 Pa·s. This viscosity is significantly lower than that of molten solder not treated with the organic fatty acid-containing solution (about 0.005 to 0.007 Pa·s). As a result, the molten solder has high fluidity and readily fills the fine through-holes.

In the manufacturing method of a substrate having fine through-holes filled with metal according to the present invention, the metal solder layer forming step is preferably performed in a vapor atmosphere of the organic fatty acid-containing solution.

In the manufacturing method of a substrate having fine through-holes filled with metal according to the present invention, the metal solder layer forming step is performed by injecting the molten solder in a direction of the plurality of fine through-holes or at a predetermined angle.

In the manufacturing method of a substrate having fine through-holes filled with metal according to the present invention, the molten solder removing step is performed by injecting a liquid flow of the organic fatty acid-containing solution.

The manufacturing method of a substrate having fine through-holes filled with metal according to the present invention preferably further comprises, in a case in which the conductive layer is formed on a substrate surface in addition to the inner wall surface of each of the plurality of fine through-holes, a conductive layer removing step of removing the conductive layer formed on the substrate surface before the metal solder layer forming step.

In the manufacturing method of a substrate having fine through-holes filled with metal according to the present invention, the conductive layer forming step includes a first conductive layer forming step of forming a first conductive layer on the inner wall surface, and a second conductive layer forming step of forming a second conductive layer composed of a copper plating layer or a copper alloy plating layer, on the first conductive layer. It should be noted that the copper plating layer or the copper alloy plating layer is preferably formed by electroless plating, which facilitates formation of a plating layer with uniform thickness.

In the manufacturing method of a substrate having fine through-holes filled with metal according to the present invention, the first conductive layer forming step is preferably performed by a PVD method or a CVD method of forming a conductive material selected from ITO, Cr, Ti, Al, Au, Ag, Cu, Ni, and Mo, or a composite material thereof.

In the manufacturing method of a substrate having fine through-holes filled with metal according to the present invention, the conductive layer forming step is a step of providing an electroless plating catalyst on the inner wall surface and subsequently forming an electroless copper plating layer or an electroless copper alloy plating layer. In this way, a conductive layer composed of an electroless copper plating layer or an electroless copper alloy plating layer is formed without providing the first conductive layer that functions as an underlayer for the copper plating layer or the copper alloy plating layer.

### Effect of the Invention

According to the present invention, a plating liquid or chemical components constituting the plating liquid do not remain in the through-holes and defects and voids do not occur in the through-hole conductors such as in the case of filling by conventional electroplating, enabling a reduction in diameter and a narrowing in pitch of long through-holes with high reliability. Accordingly, the present invention provides a substrate having fine through-holes filled with metal that facilitates high-density mounting and high reliability, and a manufacturing method thereof. In particular, the present invention provides a substrate having fine through-holes filled with metal and a manufacturing method thereof that can significantly suppress copper dissolution occurring in conventional dipping treatment and, moreover, does not cause copper dissolution in various subsequent mounting steps.

### BRIEF DESCRIPTION OF THE DRAWINGS

Fig. 1 is a sectional photograph of an example of a substrate having fine through-holes filled with metal according to the present invention (through-hole diameter of 40 µm).
Fig. 2 is a sectional photograph of another example of the substrate having fine through-holes filled with metal according to the present invention (through-hole diameter of 20 µm).
Fig. 3A is a plane photograph showing an example of the substrate having fine through-holes filled with metal according to the present invention, and Fig. 3B is an enlarged photograph thereof.
Fig. 4 is an electron micrograph showing an example of a substrate formed with fine through-holes and prepared for manufacturing the substrate having fine through-holes filled with metal.
Fig. 5 is an electron micrograph showing a form after formation of a first conductive layer in the through-holes.
Figs. 6A and 6B are structure photographs of a metal solder layer formed with a molten solder treated with an organic fatty acid-containing solution.
Figs. 7A and 7B are structure photographs of the metal solder layer formed with a molten solder not treated with the organic fatty acid-containing solution.
Figs. 8A to 8E are explanatory views illustrating an example of manufacturing steps of the substrate having fine through-holes filled with metal according to the present invention.
Figs. 9A to 9F are explanatory views illustrating another example of the manufacturing steps of the substrate having fine through-holes filled with metal according to the present invention.
Figs. 10A to 10E are explanatory views illustrating yet another example of the manufacturing steps of the substrate having fine through-holes filled with metal according to the present invention.
Fig. 11A is a schematic sectional view of an intermetallic compound layer formed between a copper plating layer and the metal solder layer in the present invention, and Fig. 11B is a schematic sectional view of the intermetallic compound layer formed with a general molten solder.
Fig. 12 is a graph showing temperature dependence of viscosity for (a) the molten solder treated with the organic fatty acid-containing solution and (b) the molten solder not treated with the organic fatty acid-containing solution.
Fig. 13 is a schematic explanatory view illustrating a step of injecting the molten solder to form the metal solder layer.
Fig. 14 is a schematic explanatory view illustrating a step of injecting the organic fatty acid-containing solution to remove excess molten solder.
Fig. 15 is a schematic explanatory view illustrating an example of the step of injecting the molten solder to form the metal solder layer and the step of injecting the organic fatty acid-containing solution to remove the excess molten solder.
Fig. 16 is a schematic explanatory view illustrating another example of the step of injecting the molten solder to form the metal solder layer and the step of injecting the organic fatty acid-containing solution to remove the excess molten solder.

### Embodiments of the Invention

A substrate having fine through-holes filled with metal and a manufacturing method thereof according to the present invention will now be described with reference to the drawings. The following embodiments represent preferred embodiments of the present invention, but the invention is not limited to these embodiments and includes various applications and modifications.

It should be noted that, in this application, "the present invention" can be rephrased as "the embodiments of this application." A "copper-dissolution preventing layer" refers to a layer that prevents copper or a copper alloy from diffusing into and dissolving in molten solder (i.e., the dissolution of copper atoms into the solder, also referred to as "copper leaching" in soldering terminology). An inner wall surface refers to an inner peripheral surface of a fine through-hole 2, and a substrate surface refers to an upper surface and/or a lower surface of a substrate. "Upper," "lower," "upward," and "downward" refer to up and down in a case of a planar view of the drawings.

### [Substrate having fine through-holes filled with metal and Manufacturing Method Thereof]

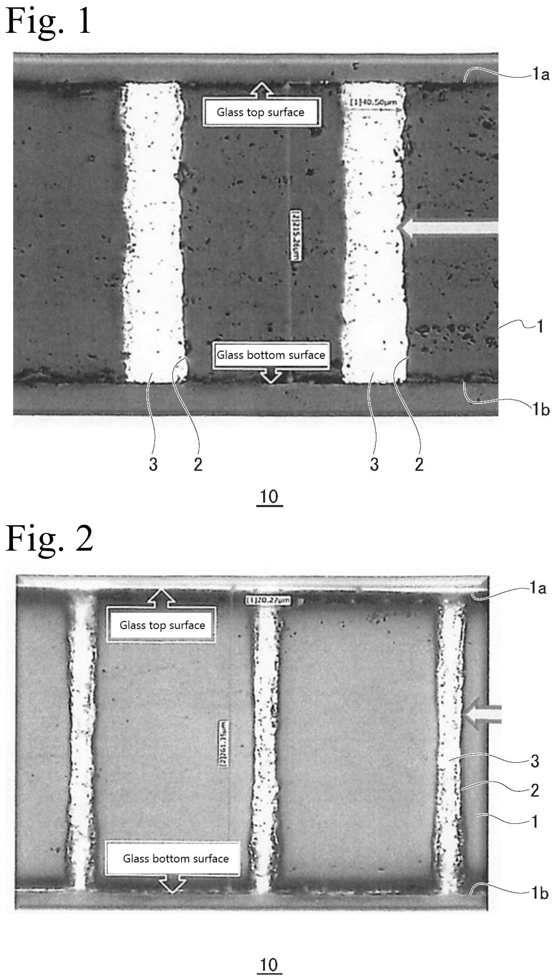

As shown in Fig. 1 to Fig. 3, a substrate 10 having fine through-holes filled with metal according to the present invention is the substrate 10 having fine through-holes filled with metal including a substrate 1 formed with a plurality of the fine through-holes 2. Each of the fine through-holes 2 is filled with a conductive layer (at least 3b) formed on an inner wall surface thereof, and a metal solder layer 3c formed on the conductive layer. The conductive layer is obtained by forming a copper plating layer on the metal solder layer side. The metal solder layer 3c is obtained by being filled with a nickel-containing molten solder treated with an organic fatty acid-containing solution.

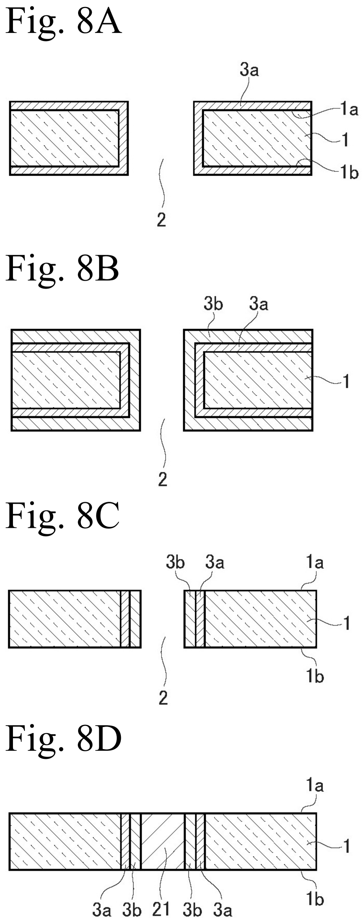

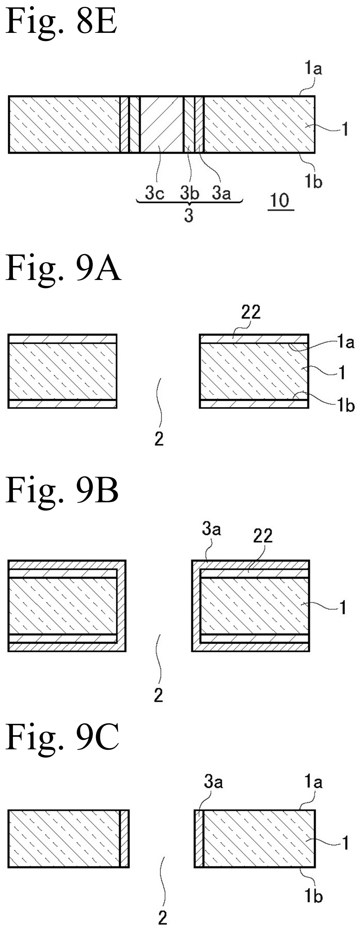

As illustrated in Fig. 8 to Fig. 10, the manufacturing method of such a substrate 10 having fine through-holes filled with metal includes a conductive layer forming step of forming, on an inner wall surface of each of the fine through-holes 2, a conductive layer composed of a copper plating layer or a copper alloy plating layer on a metal solder layer side, and a metal solder layer forming step of supplying a nickel-containing molten solder 5 treated with an organic fatty acid-containing solution onto the conductive layer on the inner wall surface to fill the fine through-holes 2 with the metal solder layer 3c.

According to the substrate 10 having fine through-holes filled with metal and the manufacturing method thereof according to the present invention, the metal solder layer 3c obtained by solidification of the molten solder is formed on the conductive layer (3a and 3b or at least 3b) formed on the inner wall surfaces of the fine through-holes 2, filling the fine through-holes 2 with the metal solder layer 3c. In the fine through-holes filled with such a metal solder layer 3c, a plating liquid and chemical components constituting the plating liquid such as in the prior art do not remain, and defects and voids do not occur in the filled metal layer 3. As a result, a substrate 10 having fine through-holes filled with metal, which facilitates high-density mounting and provides high reliability, is obtained. Further, the molten solder 5 is obtained by performing a purification treatment with the organic fatty acid-containing solution, and thus oxygen components, metal oxides, impurities, and the like present in the molten solder are purified and removed, resulting in an advantage that defects and voids are not formed in the metal solder layer 3c. Furthermore, the molten solder 5 contains nickel, and thus the nickel, together with copper and tin, form an intermetallic compound layer 4 that prevents copper dissolution. As a result, copper dissolution in the copper plating layer constituting the conductive layer is suppressed, and generation of a copper-tin alloy (CuSn intermetallic compound layer 7) having inferior mechanical strength is suppressed. It should be noted that the molten solder 5 treated with the organic fatty acid-containing solution has low oxygen content compared with untreated molten solder, and the difference can be confirmed in that a fine granular crystal structure is observed and a columnar structure such as that of the untreated molten solder is not observed.

Further, when the metal solder layer 3c is formed with the molten solder 5 treated with the organic fatty acid-containing solution, an organic fatty acid-containing solution 21 is in a state of having infiltrated into the fine through-holes 2 (refer to Fig. 8 to Fig. 10), and thus the molten solder 5 treated with the organic fatty acid-containing solution 21 readily infiltrates into the fine through-holes 2. As a result, it is possible to readily fill long or small-diameter through-holes with the metal solder layer 3c and enable a reduction in diameter and a narrowing in pitch of the through-holes with high reliability.

Hereinafter, each constituent element will be described in detail.

### <Substrate>

The substrate is not particularly limited, and various substrates provided with fine through-holes can be applied. Examples include paper phenol substrates (FR-1, FR-2, and the like), paper epoxy substrates (FR-3 and the like), glass composite substrates (CEM-3 and the like), glass epoxy substrates, glass polyimide substrates, high-frequency substrates (fluororesin substrates such as polytetrafluoroethylene (PTFE), and the like), metal-based substrates (aluminum-based substrates and the like), polyphenylene oxide (PPO) substrates, bismaleimide triazine (BT) resin substrates, ceramic substrates (alumina substrates and the like), low-temperature co-fired ceramic substrates (LTCC substrates), glass substrates (FR-4 and the like), glass core substrates, quartz substrates, and the like.

Quartz substrates and glass substrates are preferably used as the substrates. Glass substrates and quartz substrates have advantages such as high degrees of freedom in thickness and size, ease of availability, relatively low cost, excellent smoothness and flatness, suitability for forming fine wiring with a narrow pitch, a small coefficient of linear thermal expansion, excellent mounting stability and dimensional stability, excellent chemical stability, and high insulation properties and excellent transmission characteristics. They also allow fine through-holes to be machined by electric-discharge machining or laser machining. By applying such quartz substrates or glass substrates, it is possible to provide a substrate having fine through-holes filled with metal that enables high-density mounting and high reliability. In particular, when manufacturing a substrate having fine through-holes filled with metal, the substrate may be exposed to injection of molten solder heated to around 250 °C, or to processing temperatures of 150 °C to 300 °C. Even under such temperatures, by applying quartz substrates or glass substrates, which have a small coefficient of linear thermal expansion and exhibit excellent dimensional stability and chemical stability, it is possible to manufacture a substrate having fine through-holes filled with metal that enables high-density mounting and high reliability.

Glass substrates and quartz substrates are beneficial in that it is easy to machine by electric-discharge machining and laser machining, making it possible to lengthen the through-holes and enable a reduction in diameter and a narrowing in pitch of the through-holes. Although electric-discharge machining and laser machining are not described in detail in this application, known methods can be adopted. Further, through-holes can be formed with a predetermined diameter and at a predetermined pitch in glass substrates and quartz substrates having a desired thickness.

A thickness, a size, an area, and a substrate surface shape of the substrate 1 are not particularly limited, but examples include a thickness of about 0.1 mm to 1 mm, and a substrate surface shape of a square shape, a circular shape, an elliptical shape, and the like.

### <Fine through-holes>

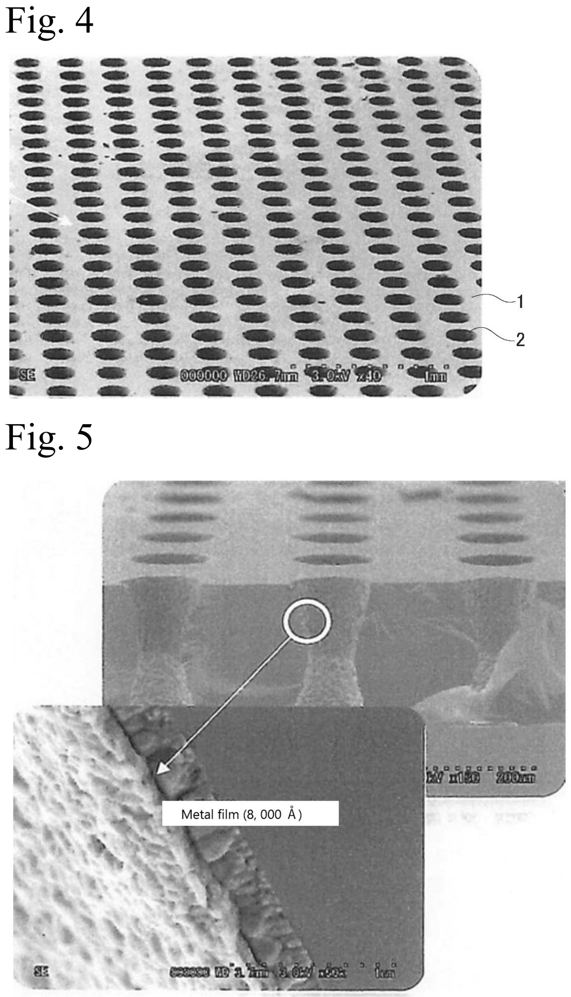

As shown in Fig. 4, the fine through-holes 2 are holes provided in the substrate 1, and those with plating applied to the inner wall surfaces thereof are generally called through-holes. In the present invention, all of the through-holes 2 are filled with a conductive layer and metallized. In this application, in this case as well, such holes may be called through-holes for convenience. Such fine through-holes 2 can be formed by electric-discharge machining, laser machining, or the like as described above.

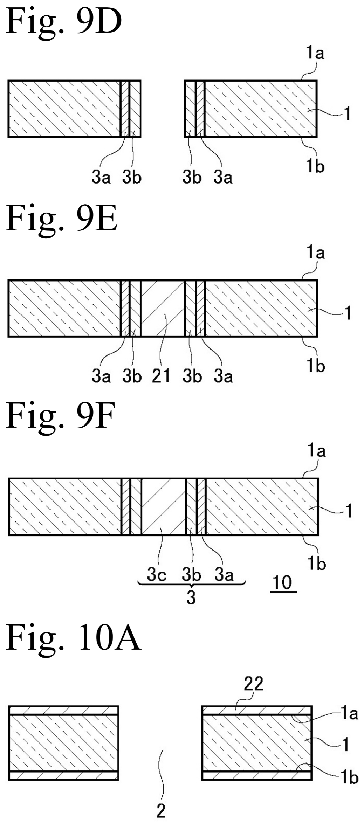

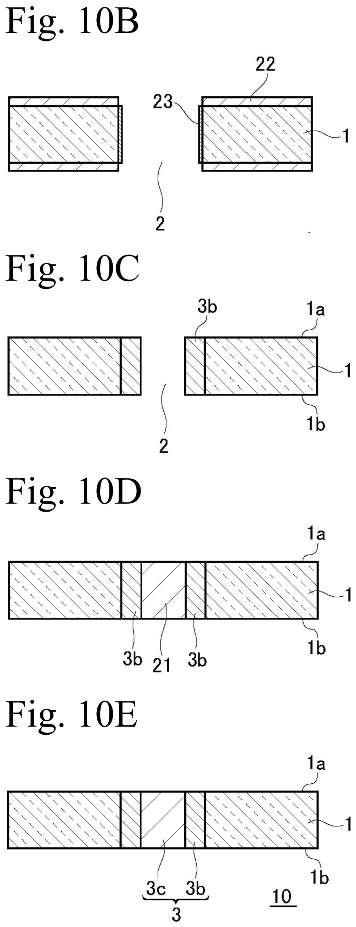

As shown in Fig. 1 to Fig. 3, interiors of the fine through-holes 2 are filled with a conductive material. Specifically, the metal layer 3, formed by a manufacturing method that is without residual plating liquid or plating liquid components, is formed on the inner wall surfaces of the fine through-holes 2. Examples of configurations of the metal layer 3 include, as described later in explanation sections of Fig. 8 and Fig. 9, a configuration including the first conductive layer 3a provided on the inner wall surface of the fine through-hole 2, the second conductive layer 3b composed of a copper plating layer or a copper alloy plating layer provided on the first conductive layer 3a, and the metal solder layer 3c provided on the second conductive layer 3b to fill the fine through-hole 2. Further, as illustrated in Fig. 10, examples include a configuration including the conductive layer 3b composed of a copper plating layer or a copper alloy plating layer provided on the inner wall surface of the fine through-hole 2 and the metal solder layer 3c provided on the conductive layer 3b to fill the fine through-hole 2.

A through-length of the fine through-hole 2 is not particularly limited, but examples include a range of 0.1 mm to 1 mm, which is the thickness of the substrate. Further, a diameter of the fine through-hole 2 is also not particularly limited, but examples include a range of 5 µm to 500 µm. In particular, the fine through-hole 2 is set within ranges of a length of 0.1 mm to 0.5 mm and a diameter of 10 µm to 50 µm, making it possible to provide a substrate having fine through-holes filled with metal to enable a reduction in diameter and a narrowing in pitch of long through-holes.

The fine through-hole 2 can also be expressed by a depth ratio (aspect ratio: L/D) when a depth (L) of the fine through-hole 2 is divided by a diameter (D) of the fine through-hole 2. For example, L/D may be 4 or greater, or L/D may be 10 or greater or 20 or greater.

A pitch of the fine through-holes 2 is also not particularly limited, but is designed in consideration of a relationship with the hole diameter. According to the present invention, narrow the pitch and, for example, set the pitch to 50 µm to 200 µm.

### <Metal layer>

As shown in Fig. 1 to Fig. 3, the fine through-holes 2 are filled with the metal layer 3. The metal layer 3 can be formed by steps such as exemplified in Fig. 8 to Fig. 10. A feature of the present invention lies in that the metal layer ultimately used for filling is the metal solder layer 3c, and the metal solder layer 3c is obtained by being filled with the nickel-containing molten solder 5 treated with the organic fatty acid-containing solution 21.

### (Metal solder layer 3c)

First, the metal solder layer 3c will be described. The metal solder layer 3c is provided on the conductive layer 3b composed of a copper plating layer or a copper alloy plating layer previously formed (refer to Fig. 8 to Fig. 10) to fill the fine through-holes 2. It should be noted that, in Fig. 8 and Fig. 9, the conductive layer 3b is provided on the first conductive layer 3a to form a two-layer structure together with the first conductive layer 3a. Further, in Fig. 10, the conductive layer 3b is composed of a copper plating layer or a copper alloy plating layer.

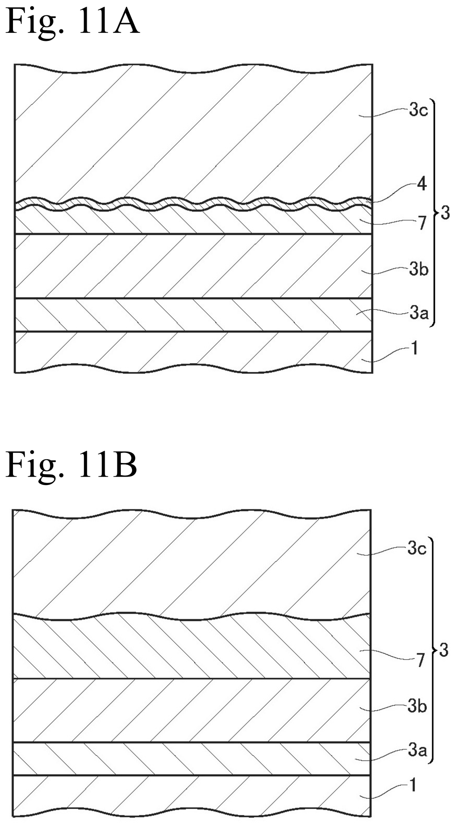

As illustrated in Fig. 11, on the conductive layer 3b side or the second conductive layer 3b side of the metal solder layer 3c, the intermetallic compound layer 4 that combines with a copper component constituting the conductive layer 3b or the second conductive layer 3b to prevent copper dissolution is formed. This metal solder layer 3c is obtained by being filled with the nickel-containing molten solder 5 treated with the organic fatty acid-containing solution 21, and thus the nickel, together with copper and tin, form the intermetallic compound layer 4 that prevents the copper dissolution. As a result, through the generation of the intermetallic compound layer 4, copper dissolution in the copper plating layer constituting the conductive layer 3b or the second conductive layer 3b is suppressed, and the generation of a copper-tin alloy (CuSn intermetallic compound layer 7) having inferior mechanical strength is suppressed.

The metal solder layer 3c contains tin as a main component and at least nickel as a subcomponent. More preferably, the metal solder layer 3c contains, as optional subcomponents, one or two or more components selected from silver, copper, zinc, bismuth, antimony, and germanium. The metal solder layer 3c having such a component composition is formed, making it possible to provide a substrate 10 having fine through-holes filled with metal having high reliability.

### (Molten solder)

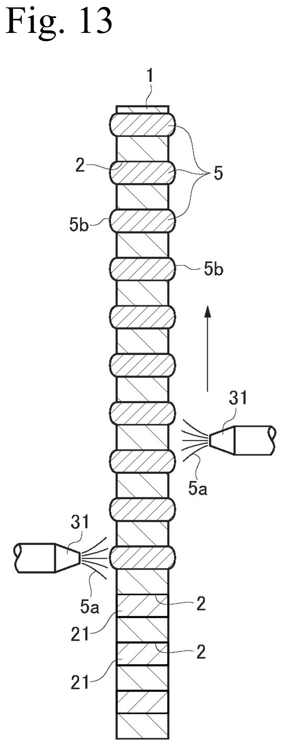

As the specific molten solder 5 used to form the metal solder layer 3c, a lead-free molten solder containing tin as a main component and at least nickel as a subcomponent is preferably used. Further, a low-melting-point molten solder containing at least nickel as a subcomponent in a tin-bismuth-based solder is also preferably used. Such a lead-free molten solder may further optionally contain, as subcomponents, one or two or more components selected from copper, germanium, and phosphorus. In addition, silver may be further contained to improve wettability. For example, an SnNi-based solder, an SnCuNi-based solder, an SnGeNi-based solder, an SnPNi-based solder, an SnCuGeNi-based solder, an SnCuGePNi-based solder, an SnAgCuNi-based solder, an SnZnAlNi-based solder, an SnAgCuGeNi-based solder, an SnSbNi-based solder, and the like can be used. Furthermore, examples of the low-melting-point solder include an SnBiNi-based solder, an SnBiZnNi-based solder, an SnBiAgInNi-based solder, and the like. Such a molten solder 5 is injected as a liquid flow 5a of the molten solder 5, obtained by heating and melting, toward the fine through-holes 2 from injection nozzles 31 (filling means), as illustrated in Fig. 13. A heating temperature is selected as desired depending on the solder composition, but is typically set to a favorable temperature within a range of 150°C to 300°C.

Examples of the molten solder 5 particularly preferred include a quinary Sn-Ni-Ag-Cu-Ge-based solder alloy, a quaternary Sn-Ni-Cu-Ge-based solder alloy, a ternary Sn-Ni-Cu-based solder alloy, and a ternary Sn-Ni-Ge-based solder alloy. The quinary Sn-Ni-Ag-Cu-Ge-based solder is preferably, for example, a solder alloy of nickel: 0.01 mass% to 0.5 mass%, silver: 2 mass% to 4 mass%, copper: 0.1 mass% to 1 mass%, and germanium: 0.001 mass% to 0.02 mass%, with the remainder being tin. The quaternary Sn-Ni-Cu-Ge-based solder is preferably, for example, a solder alloy of nickel: 0.01 mass% to 0.5 mass%, copper: 0.1 mass% to 1 mass%, and germanium: 0.001 mass% to 0.02 mass%, with the remainder being tin. The ternary Sn-Ni-Cu-based solder is preferably, for example, a solder alloy of nickel: 0.01 mass% to 0.5 mass% and copper: 0.1 mass% to 1 mass%, with the remainder being tin. The molten solder 5 composed of these solder alloys is preferred for forming, as the copper dissolution preventing layer 4, the CuNiSn intermetallic compound layer 4 capable of stably suppressing the copper dissolution in the copper plating layer or the copper alloy plating layer constituting the conductive layer 3b. A particularly preferred composition for forming such a CuNiSn intermetallic compound layer 4 is a solder alloy containing nickel: 0.01 mass% to 0.1 mass%. In a case of soldering with such a solder alloy, usage as the molten solder 5 at a temperature of 240°C to 260°C is preferred.

In addition, a low-melting-point solder containing bismuth can further reduce a heating temperature of the molten solder 5 and, with adjustment of a component composition thereof, reduce a soldering temperature to near 150°C, for example. The solder composition containing bismuth also, similarly to that described above, preferably contains nickel in an amount of 0.01 mass% to 0.5 mass%, more preferably in an amount of 0.01 mass% to 0.1 mass%. By doing so, the molten solder 5 of a low-temperature type that can readily form, as the copper dissolution preventing layer, the CuNiSn intermetallic compound layer 4 can be obtained.

Further, other components such as zinc, copper, germanium, and antimony are also blended, as necessary, but, in any case, the solder composition preferably contains at least nickel in an amount of 0.01 mass% to 0.5 mass%, more preferably 0.01 mass% to 0.1 mass%.

### (Organic fatty acid-containing solution)

The molten solder 5 is treated with the organic fatty acid-containing solution. The molten solder 5 treated with the organic fatty acid-containing solution is effective for readily forming the copper dissolution preventing layer 4 on the surface of the conductive layer 3b already cleaned with the organic fatty acid-containing solution. The organic fatty acid-containing solution 21 is preferably a solution containing organic fatty acids having 12 to 20 carbons. Although organic fatty acids having 11 carbons or less can also be used, such organic fatty acids are water-absorptive and not preferred. Further, organic fatty acids having 21 carbons or more have drawbacks such as high melting points, poor permeability, and difficult handling. As a representative, palmitic acid having 16 carbons is preferred. As the organic fatty acid, usage of only palmitic acid having 16 carbons is particularly preferred, and organic fatty acids having 12 to 20 carbons, such as stearic acid having 18 carbons, for example, can also be contained, as necessary.

As the organic fatty acid-containing solution 21, a solution containing 5 mass% to 25 mass% organic fatty acid, with the remainder composed of ester synthetic oil, is preferably used. Such an organic fatty acid-containing solution 21 is used, making it possible to selectively capture oxides, impurities (including plating liquid component residues, the same applies hereinafter), and the like present on the surface of the conductive layer 3b formed on the inner wall surfaces of the fine through-holes 2, and clean the surface of the conductive layer 3b. The organic fatty acid-containing solution 21 containing, as the organic fatty acid, palmitic acid having 16 carbons in an amount around 10 mass% (for example, 5 mass% to 15 mass%) is particularly preferred. It should be noted that the organic fatty acid-containing solution 21 does not contain metal salts such as nickel salts or cobalt salts, or additives such as antioxidants. With a concentration of the organic fatty acid being less than 5 mass%, the effect of selectively capturing oxides, impurities, and the like present on the surface of the conductive layer 3b for purification is somewhat decreased, and therefore management at low concentrations may be complicated. On the other hand, when the concentration of the organic fatty acid exceeds 25 mass%, there are problems such as an increase in a viscosity of the organic fatty acid-containing solution 21, and an occurrence of smoke generation and unpleasant odors in high-temperature regions exceeding 280°C, for example. Accordingly, the content of the organic fatty acid is preferably 5 mass% to 20 mass% and, in a case of usage of only palmitic acid having 16 carbons, is particularly preferably a content of around 10 mass% (for example, 5 mass% to 15 mass%).

The conductive layer 3b is brought into contact with the liquid of such an organic fatty acid-containing solution 21, making it possible to remove oxides, impurities, and the like present on and clean the surface of the conductive layer 3b. Furthermore, on the surface of the conductive layer 3b brought into contact with the organic fatty acid-containing solution 21, a coating film (not illustrated) of the organic fatty acids constituting the organic fatty acid-containing solution 21 is formed. This coating film cleans the surface of the conductive layer 3b and further has the advantage of making it possible to suppress oxidation of the surface of the conductive layer 3b, thereby suppressing generation of a copper oxide film and adhesion of impurities to the extent possible. As a result, the molten solder 5 can be brought into contact with the surface of the conductive layer 3b in a state in which such oxides, impurities, and the like minimally exist on the surface of the electrode. By doing so, the copper dissolution preventing layer 4 can be formed on the cleaned surface of the conductive layer 3b with uniform thickness free from defects and the like.

A temperature of the liquid of the organic fatty acid-containing solution 21 is not particularly limited, but is preferably set to a relatively high temperature. As such a temperature, a range of 50°C to 280°C, for example, is preferred. When the temperature exceeds 280°C, smoke and unpleasant odors may occur.

### (Copper dissolution preventing layer 4)

The copper dissolution preventing layer 4 is a layer generated between the conductive layer 3b and the metal solder layer 3c when the molten solder 5 is supplied onto the conductive layer 3b to fill the fine through-holes 2 with the metal solder layer 3c, as illustrated in Fig. 11A. This copper dissolution preventing layer 4 is a compound layer formed by combining the nickel component and the tin component contained in the molten solder 5 with the copper component constituting the conductive layer 3b, and is suppressed in defects and the like to the extent possible and formed with uniform thickness. This intermetallic compound layer 4 is formed, making it possible to suppress or stop the copper dissolution in the copper (or copper alloy) plating layer that constitutes the conductive layer 3b. As a result, suppress the generation of a copper-tin alloy (CuSn intermetallic compound layer 7) having inferior mechanical strength. On the other hand, in a case in which, as a molten solder material not containing nickel, a ternary lead-free solder composed of Ag: 3 mass% and Cu: 0.5 mass%, with the remainder being Sn, is used, for example, a CuNiSn intermetallic compound layer acting as the copper dissolution preventing layer 4 does not exist and the CuSn intermetallic compound layer 7 having inferior mechanical strength is thickly generated, as illustrated in Fig. 11B.

A thickness of the copper dissolution preventing layer 4 is not particularly limited, but readily falls within a range of about 0.5 µm to 3 µm. When the copper dissolution preventing layer 4 is too thick, there is a risk of cracks or fractures occurring in the copper dissolution preventing layer itself, and thus a thickness of a thickest portion is preferably 3 µm or less. Particularly preferably, a thinnest portion and the thickest portion of the copper dissolution preventing layer 4 are 0.5 µm or greater and 3 µm or less, respectively, and an overall average thickness of the copper dissolution preventing layer 4 is 1 µm to 2 µm. It should be noted that the thickness can be calculated from results of 100 measurement points based on results of observation of a cross section by a scanning electron microscope or a transmission electron microscope.

The composition of the copper dissolution preventing layer 4 contains tin as a main component and at least nickel as a subcomponent and, in a case in which the molten solder 5 further contains one or two or more components selected from silver, copper, zinc, bismuth, antimony, and germanium, contains them as optional subcomponents. The CuNiSn intermetallic compound layer, which is the copper dissolution preventing layer 4 generated in this case, is generated by cooling to a temperature below approximately 217°C, which is the melting point of the molten solder 5. It is possible to set a minimum thickness of the generated CuNiSn intermetallic compound layer to 0.5 µm or greater, and set an average thickness within a range of 1 µm to 2 µm. Thus, a CuNiSn intermetallic compound layer that is without cracks and not brittle is uniformly generated between the conductive layer 3b and the metal solder layer 3c, and defects or loss of the conductive layer 3b due to copper dissolution contained in the conductive layer 3b are prevented.

### (Molten solder treated with organic fatty acid-containing solution)

The molten solder 5 used is one treated with the organic fatty acid-containing solution 21. Specifically, a solution containing the organic fatty acid having 12 to 20 carbons in an amount of 5 mass% to 25 mass% is heated to 180°C to 280°C, and the heated solution and the molten solder 5 are brought into contact, and stirred and mixed. By doing so, the molten solder 5 contaminated with oxides and impurities (including flux components and the like, the same applies hereinafter) before the purification treatment can be cleaned, and molten solder 5 from which oxides and impurities are removed can be obtained. Subsequently, for example, the mixed liquid containing the molten solder 5 from which oxides and impurities have been removed is introduced into a storage tank of the organic fatty acid-containing solution, and the cleaned molten solder 5 separated by a specific gravity difference in the storage tank of the organic fatty acid-containing solution is returned from a bottom portion of the storage tank of the organic fatty acid-containing solution to the storage tank of lead-free solder liquid by a pump. Such a purification treatment is performed, making it possible to suppress a rise over time of a copper concentration and an impurity concentration in the molten solder 5 used as the liquid flow, and prevent oxides and impurities from being brought into the storage tank of the lead-free solder liquid. As a result, a composition change over time of the molten solder 5 in the storage tank of the lead-free solder liquid can be suppressed, and thus the molten solder 5 having stable, high bonding reliability can be used.

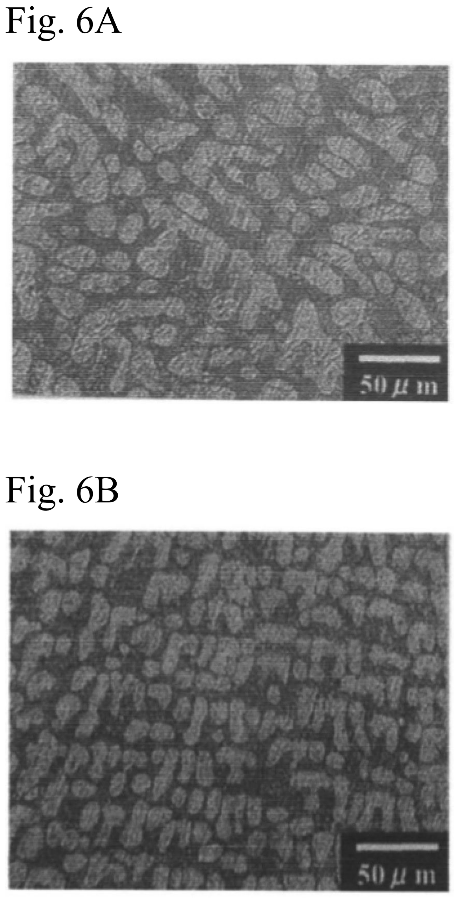

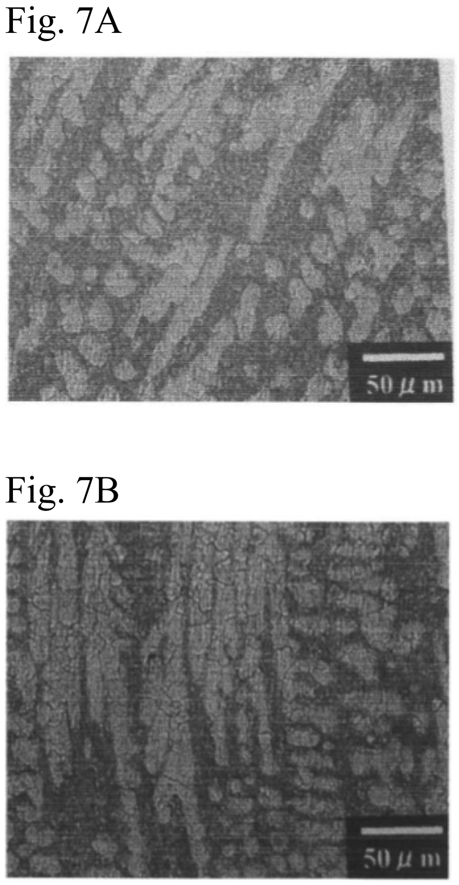

The treated molten solder 5 contains minimal oxides and impurities, making it possible to significantly reduce variation in characteristic quality of the metal solder layer 3c formed with the molten solder 5 and contribute to quality stability over time. For the treated molten solder 5, favorable results of having excellent solder wettability are obtained as compared with that of a molten solder not purified with the organic fatty acid-containing solution. It should be noted that the molten solder 5 treated with the organic fatty acid-containing solution has low oxygen content compared with untreated molten solder, and the difference can be confirmed in that a fine granular crystal structure such as shown in Figs. 6A and 6B is observed and a columnar structure such as that of the untreated molten solder (Figs. 7A and 7B) is not observed.

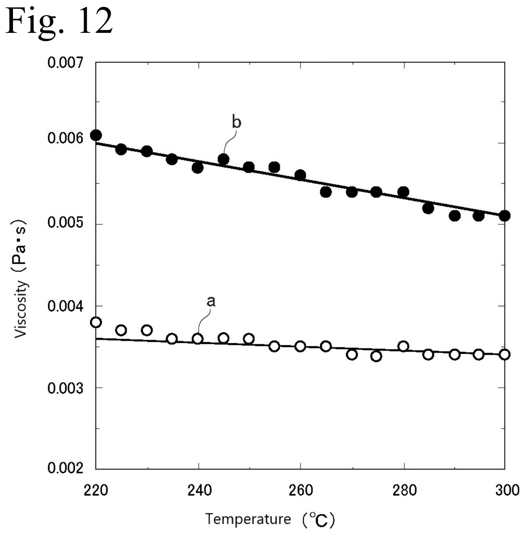

Further, for the molten solder 5 treated with the organic fatty acid-containing solution, results of having significantly low viscosity are obtained as compared with that of molten solder not purified with the organic fatty acid-containing solution. The viscosity of the molten solder 5 treated with the organic fatty acid-containing solution is within a range of 0.002 Pa·s to 0.004 Pa·s in a molten state. Specifically, in the example shown in Fig. 12, the viscosity of the molten solder 5 including a quinary lead-free solder composed of Ni: 0.05 mass%, Ge: 0.005 mass%, Ag: 3 mass%, and Cu: 0.5 mass%, with the remainder being Sn, and treated with the organic fatty acid-containing solution is 0.003 Pa·s to 0.004 Pa·s as denoted by reference sign a in Fig. 12, whereas the viscosity of the unpurified molten solder, even with the same quinary lead-free solder, is within a range of 0.005 Pa·s to 0.008 Pa·s in a molten state. Specifically, the viscosity of unpurified molten solder is 0.005 Pa·s to 0.006 Pa·s as denoted by reference sign b in Fig. 12, even with the same quinary lead-free solder, resulting in a difference of approximately 1.5 times between the two. It should be noted that the molten solders used in the examples and comparative examples described later all had melting points of about 217°C, and the viscosity ranges described above are results obtained at least within a temperature range of 240°C to 260°C. The viscosity was measured with a vibrating-piece-type viscometer.

The above-described characteristic differences (viscosity and solder wettability) between the treated molten solder 5 and the unpurified molten solder mean that, as illustrated in Fig. 13, when sprayed onto the substrate 1, the liquid flow 5a of the molten solder 5 replaces the organic fatty acid-containing solution 21 and readily infiltrates throughout every corner of the fine through-holes 2 infiltrated with the organic fatty acid-containing solution, and spreads evenly with favorable solder wettability. In particular, the organic fatty acid-containing solution 21 is infiltrated into the fine through-holes 2 before the liquid flow 5a of the molten solder 5 is sprayed onto the substrate 1 (Fig. 13), and thus the organic fatty acid-containing solution 21 removes the copper oxides, impurities, and the like present on and cleans the surface of the conductive layer 3b inside the fine through-holes 2. The liquid flow 5a of the molten solder 5 similarly purified with the organic fatty acid-containing solution and having a viscosity within the above-described range (0.002 Pa·s to 0.004 Pa·s) is injected from the injection nozzles 31 onto the surface of the conductive layer 3b thus cleaned, making it possible for the molten solder 5 to wet and spread evenly and uniformly with favorable solder wettability on the conductive layer 3b. As a result, the nickel component and the tin component contained in the molten solder 5 combine with the copper component constituting the conductive layer 3b to generate a CuNiSn intermetallic compound layer, which is the copper dissolution preventing layer 4, throughout every corner of the surface of the conductive layer 3b, and the fine through-holes 2 are filled without gaps.

On the other hand, in a case in which a liquid flow of unpurified molten solder is injected onto the surface of the conductive layer 3b inside the fine through-holes 2, the unpurified molten solder has a high viscosity of 0.005 Pa·s or greater and 0.008 Pa·s or less in the molten state, does not wettably spread with favorable wettability such as described above, and thus may not be wettably spread evenly on the surface of the conductive layer 3b.

A temperature of the organic fatty acid-containing solution used for purification is determined by a melting point of the molten solder 5 to be purified, and the organic fatty acid-containing solution and the molten solder 5 are stirred and brought into contact in a high-temperature region at least equal to or higher than the melting point of the molten solder 5 (as an example, 240°C to 260°C for solder with a melting point around 217°C). Further, an upper-limit temperature of the organic fatty acid-containing solution is about 280°C from the viewpoints of smoking problems and energy conservation, and is desirably within a range from a temperature equal to or higher than the melting point of the molten solder 5 to be purified to 260°C. For example, a solder alloy of nickel: 0.01 mass% to 0.1 mass%, silver: 0.1 mass% to 4 mass%, copper: 0.1 mass% to 1 mass%, and germanium: 0.001 mass% to 0.01 mass%, with the remainder being tin has a melting point around 217°C and is used as the molten solder 5 at a temperature of 240°C to 260°C, and thus the temperature of the organic fatty acid-containing solution is also preferably at the same level of about 240°C to 260°C.

### <Conductive layer other than metal solder layer>

Other than the above-described metal solder layer 3c constituting the metal layer 3, the conductive layer may be a conductive layer formed on the inner wall surfaces of the fine through-holes 2. Examples of the conductive layer include the first conductive layer 3a provided on the inner wall surfaces of the fine through-holes 2 and the second conductive layer 3b composed of a copper plating layer or a copper alloy plating layer provided on the first conductive layer 3a, as illustrated in Fig. 8 and Fig. 9. The metal solder layer 3c can be provided on such a conductive layer having a two-layer structure to fill the fine through-holes 2. Further, the conductive layer having another form, for example, as illustrated in Fig. 10, may be the conductive layer 3b composed of a copper plating layer or a copper alloy plating layer directly provided on the inner wall surfaces of the fine through-holes 2 without providing the first conductive layer 3a. The metal solder layer 3c may be provided on such a conductive layer 3b to fill the fine through-holes 2.

### (Conductive layer 3b, second conductive layer 3b)

The layer represented by reference sign 3b is a copper plating layer or a copper alloy plating layer provided as a lower layer of the metal solder layer 3c described above. The layer is the "second conductive layer 3b" in Fig. 8 and Fig. 9, and the "conductive layer 3b" in Fig. 10. Such a copper plating layer or a copper alloy plating layer is preferably an electroless plating layer readily formed with uniform plating thickness.

The plating liquid for forming the electroless copper plating layer is not particularly limited, but examples include an electroless copper plating liquid containing sodium hypophosphite as a reducing agent, and the plating liquid for forming the electroless copper alloy plating layer is also not particularly limited, but examples include an electroless copper-nickel plating liquid containing sodium hypophosphite as a reducing agent. A thickness of the formed electroless plating layer is not particularly limited, but may be, for example, about 1 µm to 10 µm, and is preferably 2 µm to 6 µm. Such thickness can be measured with a thickness meter or a cross section can be measured with a microscope.

It should be noted that, as the electroless copper plating method, general reduction-type electroless copper plating that is industrially used can be applied. The reduction-type electroless plating may be a non-catalytic type or may be an autocatalytic type, and is not particularly limited. Examples of the electroless plating liquid include those containing copper salts (such as copper sulfate or copper chloride, for example), reducing agents (such as formaldehyde, glyoxylic acid, hypophosphites, or dimethylamine borane (DMAB), for example), complexing agents (such as Rochelle salt or ethylenediaminetetraacetic acid (EDTA), for example), pH adjusters, stabilizers, and the like.

### (First conductive layer 3a)

As exemplified in Fig. 5, the first conductive layer 3a is provided on the inner wall surfaces of the fine through-holes 2, and provided as a lower layer in a case in which the second conductive layer 3b is formed. Such a first conductive layer 3a is a conductive material selected from ITO, Cr, Ti, Al, Au, Ag, Cu, Ni, and Mo or a composite material thereof, and is preferably a PVD film or a CVD film formed by a physical vapor deposition (PVD) method or a chemical vapor deposition (CVD) method. The above-described material is used for the first conductive layer 3a, making it possible to readily form the second conductive layer 3b composed of an electroless plating layer on the first conductive layer 3a. A thickness of the first conductive layer 3a is not particularly limited, but can be set within a range of about 0.1 µm to 1.5 µm and may be set to about 0.2 µm to 1 µm.

### (Other)

In the substrate 10 having fine through-holes filled with metal in which the fine through-holes 2 are filled with such a configuration, a wiring pattern may be formed on one or both substrate surfaces 1a and 1b. Further, the metal solder layer 3c is made flush with the substrate surface by removing the molten solder 5 protruding from the substrate surface by a molten solder removing step. However, in a case in which the molten solder 5 is not removed or slightly removed, the metal solder layer 3c may be protruded from the substrate surfaces 1a and 1b. The metal solder layer 3c is protruded from the substrate surfaces 1a and 1b, making it possible to utilize protrusion portions as wiring or lands.

### (Substrate having fine through-holes filled with metal)

In the substrate 10 having fine through-holes filled with metal thus configured, a plating liquid and chemical components constituting the plating liquid such as in the prior art do not remain in the fine through-holes 2 filled with the metal solder layer 3c, and defects and voids do not occur in the filled metal layer 3. As a result, the substrate having fine through-holes filled with metal that facilitates high-density mounting and high reliability is obtained. Further, the molten solder 5 is subjected to the purification treatment with the organic fatty acid-containing solution 21, and thus oxygen components, metal oxides, impurities, and the like present in the molten solder 5 are purified and removed, and defects and voids are not formed in the metal solder layer 3c. Furthermore, the molten solder 5 contains nickel, and thus the nickel, together with copper and tin, form the intermetallic compound layer 4 that prevents the copper dissolution. As a result, the copper dissolution constituting the conductive layer 3b is suppressed, and the generation of a copper-tin alloy having inferior mechanical strength is suppressed.

### <Manufacturing method>

The manufacturing method of the substrate 10 having fine through-holes filled with metal according to the present invention, as exemplified in Fig. 8 to Fig. 10, is a manufacturing method of the substrate 10 having fine through-holes filled with metal including the substrate 1 formed with the plurality of the fine through-holes 2 filled with the metal solder layer 3c. The manufacturing method includes a conductive layer forming step of forming, on the inner wall surface of each of the fine through-holes 2, the conductive layer 3b formed with a copper plating layer on the metal solder layer 3c side, and a metal solder layer forming step of supplying the liquid flow 5a of the nickel-containing molten solder 5 treated with the organic fatty acid-containing solution 21 onto the conductive layer 3b on the inner wall surface to fill the fine through-hole with a metal solder layer.

### (Conductive layer forming step)

The conductive layer forming step is a step of forming, on the inner wall surface of each of the fine through-holes 2, the conductive layer 3b composed of a copper plating layer or a copper alloy plating layer on the metal solder layer 3c side.

This conductive layer forming step may include <Step Example 1> the first conductive layer forming step of forming the first conductive layer 3a on the inner wall surfaces of the fine through-holes 2, and the second conductive layer forming step of forming, on the first conductive layer 3a, the second conductive layer 3b composed of a copper plating layer or a copper alloy plating layer, as exemplified in Figs. 8A to 8C and Figs. 9A to 9D, or may be <Step Example 2> a step of providing an electroless plating catalyst 23 on the inner wall surfaces of the fine through-holes 2 and subsequently forming the conductive layer 3b composed of an electroless copper plating layer or an electroless copper alloy plating layer, as illustrated in Fig. 10. In the conductive layer forming step of Step Example 2, the conductive layer 3b composed of an electroless copper plating layer or an electroless copper alloy plating layer can be formed without providing the first conductive layer that functions as an underlayer for the conductive layer 3b composed of the copper plating layer or the copper alloy plating layer.

It should be noted that, as illustrated in Fig. 8B, in a case in which the conductive layers (3a, 3b) are formed on the substrate surfaces 1a and 1b in addition to the inner wall surfaces of the fine through-holes 2, a conductive layer removing step of removing the conductive layers (3a, 3b) formed on the substrate surfaces 1a and 1b is preferably included before the metal solder layer forming step in Fig. 8E. A removing means at this time is not particularly limited, but the conductive layers (3a, 3b) on the substrate surfaces 1a and 1b can be removed by mechanical polishing.

Further, it is also possible to provide a resist film 22 only on the substrate surfaces 1a and 1b as illustrated in Fig. 9A, subsequently form the first conductive layer 3a on the substrate surfaces 1a and 1b and inside the fine through-holes 2 by the above-described method as illustrated in Fig. 9B, and subsequently peel away the resist film to remove the first conductive layer 3a provided on the substrate surfaces 1a and 1b as illustrated in Fig. 9C. Subsequently, form an electroless plating on the first conductive layer 3a and form the first conductive layer 3a and the second conductive layer 3b inside the fine through-holes 2, as illustrated in Fig. 9D. Subsequently, it is also possible to fabricate the substrate 10 having fine through-holes filled with metal by a procedure similar to that in Fig. 8 and Fig. 10.

### (Organic fatty acid-containing solution infiltrating step)

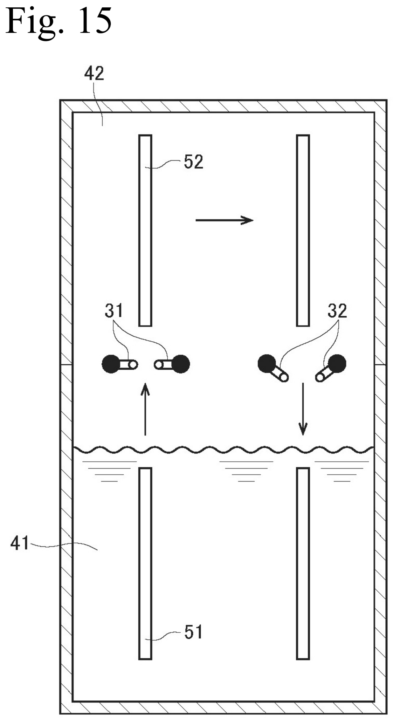

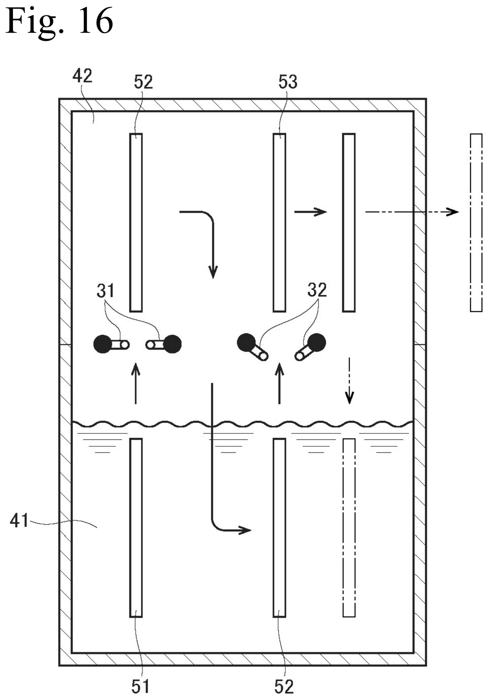

After the conductive layer forming step and before the metal solder layer forming step, an organic fatty acid-containing solution infiltrating step of infiltrating the organic fatty acid-containing solution 21 into the fine through-holes 2 as illustrated in Fig. 8D, Fig. 9E, and Fig. 10D is included. By this organic fatty acid-containing solution infiltrating step, the organic fatty acid-containing solution 21 is infiltrated into the fine through-holes 2 before formation of the metal solder layer 3c, and the molten solder 5 treated with the organic fatty acid-containing solution 21 can readily infiltrate into the fine through-holes 2. As a result, long or small-diameter through-holes can be readily filled with the metal solder layer, enabling a reduction in diameter and a narrowing in pitch of the through-holes with high reliability. To facilitate the infiltration of the organic fatty acid-containing solution 21, a means for depressurizing a space 42 inside a container in Fig. 15 and Fig. 16, for example, may be applied. A depressurized state is made, making it possible to remove air and air bubbles present in the fine through-holes 2 through a so-called degassing phenomenon and readily infiltrate the organic fatty acid-containing solution into the fine through-holes 2.

In particular, the organic fatty acid-containing solution infiltrating step preferably includes, before the infiltration of the organic fatty acid-containing solution 21 into the fine through-holes 2, a liquid infiltrating step of infiltrating a cleaning liquid or a surface treatment liquid into the fine through-holes. In this way, a liquid (cleaning liquid or surface treatment liquid) is infiltrated into the fine through-holes 2 in advance, making it possible to readily perform a liquid-liquid exchange between the liquid and the organic fatty acid-containing solution 21. As a result, the organic fatty acid-containing solution 21 infiltrates throughout every corner of the fine through-holes 2, selectively captures and removes oxides and impurities (including plating liquid component residues) present on the surface of the conductive layer 3b inside the fine through-holes 2, and cleans the surface of the conductive layer 3b. It should be noted that the cleaning liquid may be an aqueous solvent or an organic solvent, and the surface treatment liquid may be an oxide removing solution or the like. In this case as well, a means for depressurization may be applied to facilitate infiltration of the cleaning liquid or the surface treatment liquid. A depressurized state is made, making it possible to remove air and air bubbles present in the fine through-holes 2 through a so-called degassing phenomenon, and readily infiltrate the cleaning liquid or the surface treatment liquid into the fine through-holes 2.

### (Metal solder layer forming step)

The metal solder layer forming step is a step of supplying the liquid flow 5a of the nickel-containing molten solder 5 treated with the organic fatty acid-containing solution 21 onto the conductive layer 3b on the inner wall surfaces of the fine through-holes 2 to fill the fine through-holes 2 with the metal solder layer 3c. The formation of the metal solder layer 3c by the molten solder 5 has already been described in detail, and thus description thereof will be omitted here.

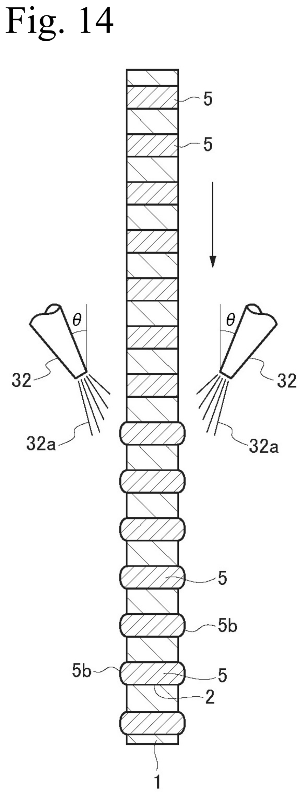

This metal solder layer forming step may include, after supplying the liquid flow 5a of the nickel-containing molten solder 5 (molten solder supplying step) as illustrated in Fig. 13, a molten solder removing step of removing excess molten solder 5b as illustrated in Fig. 14. By the molten solder removing step illustrated in Fig. 14, the excess molten solder 5b is removed. It should be noted that the removal of the excess molten solder 5b is preferably performed by injecting a liquid flow 32a of the organic fatty acid-containing solution or a gas flow of air or an inert gas, as illustrated in Fig. 14 to Fig. 16. The injection is preferably performed from injection nozzles 32, and an injection angle θ of the liquid flow 32a or the gas flow is preferably adjusted as desired for injection.

In this metal solder layer forming step, as illustrated in Fig. 15 and Fig. 16, for example, preferably the space 42 is set as a vapor atmosphere of an organic fatty acid-containing solution 41 and the metal solder layer 3c is formed in the vapor atmosphere. Further, the metal solder layer forming step is preferably performed by injecting the molten solder 5 in the direction of the fine through-holes 2 or at a predetermined angle. The examples illustrated in Fig. 13, Fig. 15, and Fig. 16 are examples of injecting the liquid flow of the molten solder from the injection nozzles 31 in the direction of the fine through-holes 2 (so as to strike the substrate surface perpendicularly).

### (Draining of organic fatty acid-containing solution)

After removal of the excess molten solder 5b by injecting the liquid flow of the organic fatty acid-containing solution, an air knife (not illustrated) may be provided, as necessary, to drain the organic fatty acid-containing solution. As illustrated in Fig. 16, the air knife is preferably applied to drain the organic fatty acid-containing solution 41 adhered to a surface of a substrate 53 lifted from the organic fatty acid-containing solution 41 and obtained by removing the excess molten solder. The gas injected from the air knife may be clean air, or may be an inert gas such as nitrogen or argon. With such draining, the organic fatty acid-containing solution 41 excessively adhered can be removed. For this draining, an air nozzle or the like is preferably used. An injection pressure of the air nozzle or the like at this time is not particularly limited and is set as desired.

It should be noted that in the context of the present invention, the term "liquid flow" of the molten solder refers to any dynamic application of the molten solder in a fluid state. This includes, but is not limited to, a continuous stream, a jet, a spray, a wave, or a pressurized flow of the molten solder. The specific flow rate or pressure is not limited, provided that the flow is capable of supplying the solder into the through-holes and facilitating the replacement of the organic fatty acid-containing solution.

### (Other constituent elements)

It should be noted that the details described in the "Configuration of substrate 10 having fine through-holes filled with metal" section are omitted in this section of the manufacturing method to avoid redundancy.

### Examples

The present invention will be described more specifically with examples.

### [Example 1]

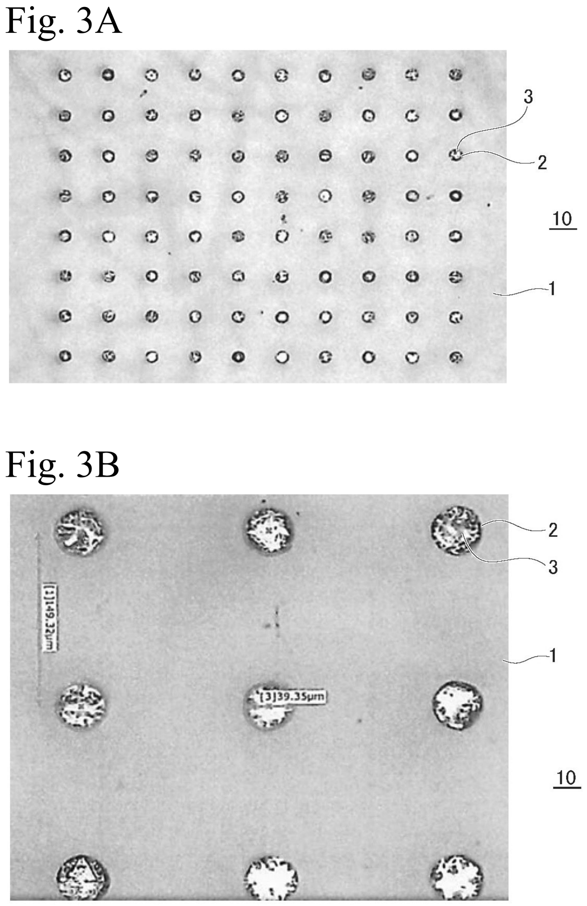

As an example, a substrate formed with fine through-holes was prepared by forming the fine through-holes 2 having a diameter of 40 µm at a pitch of 150 µm in the quartz substrate 1 having a diameter of 4 inches and a thickness of 0.22 mm. In these fine through-holes 2, as illustrated in Fig. 8A, the first conductive layer 3a having a thickness of 0.25 µm was formed on both substrate surfaces (1a, 1b) and the inner wall surfaces of the fine through-holes 2 by a sputtering method. Subsequently, as illustrated in Fig. 8B, the second conductive layer 3b having a thickness of 5 µm and composed of a copper plating layer was formed on the first conductive layer 3a by an electroless plating method using an electroless copper plating liquid as the second conductive layer 3b. Subsequently, as illustrated in Fig. 8C, the first conductive layer 3a and the second conductive layer 3b formed on the substrate surfaces 1a and 1b were removed by mechanical polishing. Subsequently, as illustrated in Fig. 8D, the organic fatty acid-containing solution 21 was infiltrated into the fine through-holes. Subsequently, as illustrated in Fig. 8E and Fig. 13, the molten solder 5 treated with the organic fatty acid-containing solution 21 was injected to fill the fine through-holes 2 with the metal solder layer 3c. Subsequently, the excess molten solder 5b was removed by a means such as illustrated in Fig. 14. Thus, the substrate 10 having fine through-holes filled with metal shown in Fig. 1 and Fig. 3 was fabricated.

The molten solder 5 used was a quinary lead-free solder composed of Ni: 0.05 mass%, Ge: 0.005 mass%, Ag: 3 mass%, and Cu: 0.5 mass%, with the remainder being Sn, and was heated to 250°C and subsequently prepared as the molten solder 5. The solder structure of the filled metal solder layer 3c was a fine granular crystal structure similar to the structure form shown in Fig. 6. Further, the copper dissolution preventing layer 4 such as illustrated in Fig. 11A was formed to suppress the generation of the CuSn intermetallic compound layer 7. In the obtained substrate 10 having fine through-holes filled with metal, the plating liquid or chemical components constituting the plating liquid did not remain in the through-holes, and defects and voids did not occur in the through-hole conductors.

### [Example 2]

As another example, a substrate formed with fine through-holes was prepared by forming the fine through-holes 2 having a diameter of 20 µm at a pitch of 150 µm in the quartz substrate 1 having a diameter of 4 inches and a thickness of 0.26 mm. Otherwise, the procedure was similar to that in Example 1, and the substrate 10 having fine through-holes filled with metal of Example 2 shown in Fig. 2 was fabricated. For this substrate 10 having fine through-holes filled with metal as well, the solder structure of the filled metal solder layer 3c was a fine granular crystal structure similar to the structure form shown in Fig. 6. Further, in Example 2 as well, the copper dissolution preventing layer 4 such as illustrated in Fig. 11A was formed to suppress the generation of the CuSn intermetallic compound layer 7. Furthermore, in the obtained substrate 10 having fine through-holes filled with metal, the plating liquid or chemical components constituting the plating liquid did not remain in the through-holes, and defects and voids did not occur in the through-hole conductors.

### [Example 3]

As yet another example, a substrate formed with 700,000 fine through-holes such as shown in Fig. 4 was prepared by forming the fine through-holes 2 having a diameter of 150 µm at a pitch of 300 µm in the alkali-free glass substrate 1 having a diameter of 12 inches and a thickness of 0.30 mm. The first conductive layer 3a was formed to a thickness of 0.8 µm (8,000 angstroms) as shown in Fig. 5. Otherwise, the procedure was similar to that in Example 1, and the substrate 10 having fine through-holes filled with metal of Example 3 was fabricated. For this substrate 10 having fine through-holes filled with metal as well, the solder structure of the filled metal solder layer 3c was a fine granular crystal structure similar to the structure form shown in Fig. 6. Further, in Example 3 as well, the copper dissolution preventing layer 4 such as illustrated in Fig. 11A was formed to suppress the generation of the CuSn intermetallic compound layer 7. Furthermore, in the obtained substrate 10 having fine through-holes filled with metal, the plating liquid or chemical components constituting the plating liquid did not remain in the through-holes, and defects and voids did not occur in the through-hole conductors.

### Descriptions of Reference Numerals

- 1: Substrate
- 1a: Substrate top surface
- 1b: Substrate bottom surface
- 2: Substrate through-hole
- 3: Metal layer
- 3a: First conductive layer
- 3b: Conductive layer (Second conductive layer)
- 3c: Metal solder layer
- 4: Copper dissolution preventing layer (Intermetallic compound layer)
- 5: Molten solder
- 5a: Liquid flow of molten solder
- 5b: Excess molten solder
- 7: CuSn compound layer
- 10: Substrate having fine through-holes filled with metal
- 21: Organic fatty acid-containing solution
- 22: Resist film
- 23: Electroless plating catalyst
- 31: Filling means (Injection nozzle of molten solder)
- 32: Injecting means (Injection nozzle for organic fatty acid-containing solution)
- 32a: Injection liquid (Organic fatty acid-containing solution)
- 41: Organic fatty acid-containing solution
- 42: Space
- 51: Substrate treated with organic fatty acid-containing solution
- 52: Substrate filled with molten solder
- 53: Substrate obtained by removing excess molten solder

## Claims

1. A substrate comprising:
a substrate body having a plurality of fine through-holes formed therein,
each of the fine through-holes being filled by a combination of
(a) a conductive layer formed on an inner wall surface thereof, the conductive layer including a copper plating layer on the metal solder layer side, and
(b) a metal solder layer formed inside the conductive layer by solidification of a nickel-containing molten solder that has been treated with an organic fatty acid-containing solution.

2. The substrate according to claim 1,
wherein the substrate is a quartz substrate or a glass substrate.

3. The substrate according to claim 1 or 2,
wherein an intermetallic compound layer that reacts with a copper component constituting the conductive layer, thereby preventing copper dissolution, is formed on the conductive layer side of the metal solder layer.

4. The substrate according to claim 1 or 2,
wherein the conductive layer is composed of a first conductive layer formed on the inner wall surface and a second conductive layer formed on the first conductive layer,
and wherein the first conductive layer is a conductive material selected from ITO, Cr, Ti, Al, Au, Ag, Cu, Ni, Mo, and combinations, alloys, or composites thereof,
and the second conductive layer is a copper plating layer or a copper alloy plating layer.

5. A method of manufacturing a substrate having a plurality of fine through-holes filled with metal, the method comprising:
forming a conductive layer on an inner wall surface of each of the fine through-holes in a substrate body, the conductive layer composed of a copper plating layer or a copper alloy plating layer; and
supplying a liquid flow of a nickel-containing molten solder that has been treated with an organic fatty acid-containing solution onto the conductive layer on the inner wall surface to fill the fine through-hole with the metal solder layer,
whereby each of the fine through-holes is filled with the conductive layer and the metal solder layer.

6. The manufacturing method according to claim 5,
wherein the metal solder layer forming step includes, after a step of supplying the nickel-containing molten solder,
a step of removing excess molten solder.

7. The manufacturing method according to claim 5 or 6, further comprising,
after the conductive layer forming step and before the metal solder layer forming step,
a step of infiltrating the organic fatty acid-containing solution into the plurality of fine through-holes.

8. The manufacturing method according to claim 7,
wherein the organic fatty acid-containing solution infiltrating step includes, before infiltrating the organic fatty acid-containing solution,
a step of infiltrating a cleaning liquid or a surface treatment liquid into the plurality of fine through-holes.

9. The manufacturing method according to claim 5 or 6,
wherein a viscosity of the molten solder is 0.002 Pa·s or greater and 0.004 Pa·s or less.

10. The manufacturing method according to claim 5 or 6,
wherein the metal solder layer forming step is performed in a vapor atmosphere of the organic fatty acid-containing solution.

11. The manufacturing method according to claim 5 or 6,
wherein the metal solder layer forming step is performed by injecting the molten solder in a direction of the plurality of fine through-holes or at a predetermined angle.

12. The manufacturing method according to claim 5 or 6,
wherein the molten solder removing step is performed by injecting a liquid flow of the organic fatty acid-containing solution.

13. The manufacturing method according to claim 5 or 6, further comprising,
in a case in which the conductive layer is formed on a substrate surface in addition to the inner wall surface of each of the plurality of fine through-holes,
a step of removing the conductive layer formed on the substrate surface before the metal solder layer forming step.

14. The manufacturing method according to claim 5 or 6,
wherein the conductive layer forming step includes
a first conductive layer forming step of forming a first conductive layer on the inner wall surface, and
a second conductive layer forming step of forming a second conductive layer composed of a copper plating layer or a copper alloy plating layer on the first conductive layer.

15. The manufacturing method according to claim 5 or 6,
wherein the conductive layer forming step is a step of providing an electroless plating catalyst on the inner wall surface and subsequently forming an electroless copper plating layer or an electroless copper alloy plating layer.
